Europäisches Patentamt

European Patent Office

Office européen des brevets

(11) Numéro de publication: **0 253 704 B1**

# FASCICULE DE BREVET EUROPEEN

(45) Date de publication de fascicule du brevet: **06.05.92** (51) Int. Cl.5: **H03F 3/45**

(21) Numéro de dépôt: **87401468.1**

(22) Date de dépôt: **25.06.87**

(54) **Amplificateur sommateur différentiel double à quatre entrées indépendantes.**

(30) Priorité: **27.06.86 FR 8609376**

(43) Date de publication de la demande:
**20.01.88 Bulletin 88/03**

(45) Mention de la délivrance du brevet:
**06.05.92 Bulletin 92/19**

(84) Etats contractants désignés:
**DE GB IT NL**

(56) Documents cités:
**EP-A- 0 019 279**
**EP-A- 0 168 198**
**DE-A- 3 232 442**
**US-A- 4 460 874**

**IEEE 1983 INTERNATIONAL SYMPOSIUM ON CIRCUITS AND SYSTEMS, Newport Beach, California, 2-4 mai 1983, vol. 3, pages 1274-1277, IEEE, New York, US; F. MALOBERTI: "MOS switched capacitor operational amplifier"**

**IBM TECHNICAL DISCLOSURE BULLETIN, vol. 9, no. 7, décembre 1966, page 949, New York, US; E.F. DONNER et al.: "Differential amplifier"**

(73) Titulaire: **COMMISSARIAT A L'ENERGIE ATOMIOUE Etablissement de Caractère Scientifique Technique et Industriel**
**31/33, rue de la Fédération**
**F-75015 Paris(FR)**

(72) Inventeur: **Corpechot, Myriam**
**5, rue Louis Moreau**
**F-91150 Etampes(FR)**
Inventeur: **Montaron, Joel**
**30/34, rue Claude Lorrain**
**F-75016 Paris(FR)**

(74) Mandataire: **Mongrédien, André et al**
**c/o BREVATOME 25, rue de Ponthieu**
**F-75008 Paris(FR)**

## Description

La présente invention a pour objet un amplificateur sommateur différentiel double à quatre entrées indépendantes.

Dans le traitement électronique des signaux analogiques tels qu'on les rencontre dans les amplificateurs opérationnels, les comparateurs et les échantillonneurs bloqueurs, il est souvent nécessaire de réaliser des combinaisons linéaires de sommes et/ou de différences de signaux donnés, éventuellement après amplification. L'état de la technique actuel n'offre, à l'homme de métier, aucun appareil répondant à ce besoin et c'est le premier but du circuit objet de l'invention de répondre à ce besoin.

Un tel circuit possède quatre branches amplificatrices et/ou sommatrices auxquelles on applique quatre tensions d'entrée et il délivre deux tensions de sortie dont la différence constitue la tension amplifiée.

Un deuxième but de ce circuit est de résoudre le problème des anomalies connues de la courbe de transfert d'un amplificateur différentiel et de son point de fonctionnement, soit à l'aide d'une commande externe soit de façon automatique.

L'Homme de l'Art sait parfaitement en effet, que lorsqu'on utilise des transistors MOS dans des circuits intégrés, il n'est pas possible de réaliser un contrôle précis en ce qui concerne le réglage des points de fonctionnement de chacun des composants pris isolément.

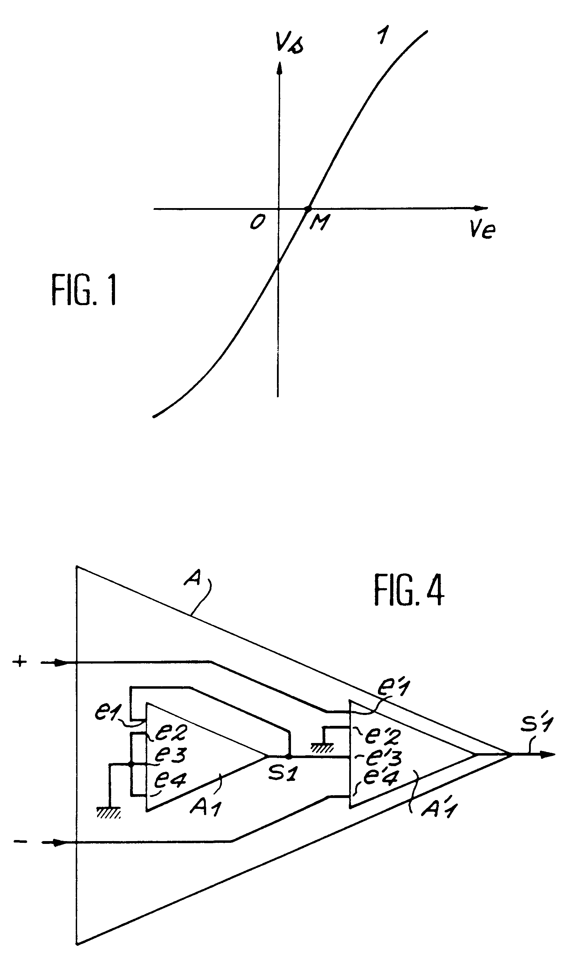

D'une façon générale, la courbe de réponse d'un amplificateur différentiel a l'allure classique représentée sur la figure 1 ci-jointe. Sur cette figure on a représenté en ordonnées la tension de sortie Vs en fonction de la tension d'entrée Ve figurant en abscisses. Classiquement, la courbe d'amplification 1 ne passe pas par l'origine des coordonnées, ce qui signifie que pour une tension d'entrée nulle, la tension de sortie n'est pas égale à zéro. Ce défaut connu des amplificateurs différentiels est appréhendé à l'aide de la notion de tension d'offset qui est précisément égale au segment OM de la figure 1, lequel représente la tension qu'il faut appliquer à l'entrée de l'amplificateur pour recueillir une tension nulle en sortie.

Dans les dispositifs amplificateurs de l'art antérieur, la correction des points de fonctionnement était réalisée jusqu'à maintenant selon diverses techniques plus ou moins efficaces et précises telles que l'ajustage de l'une des tensions d'entrée à l'aide d'un potentiomètre externe ou par commande d'une résistance à l'aide d'un laser ou encore comme c'est le cas dans le circuit amplificateur ayant fait l'objet du brevet français $n_o$ FR-A-2 318 534 au nom du même demandeur à l'aide d'un système à contre réaction de mode commun ou encore par l'utilisation d'une demi-branche de l'amplificateur etc... A ces différentes corrections, venaient s'ajouter encore des problèmes dynamiques lors du fonctionnement.

La présente invention a précisément pour objet un circuit amplificateur différentiel à quatre entrées dont deux d'entre elles sont utilisables pour modifier le point de fonctionnement, soit au gré de l'utilisateur, soit de façon automatique, et dont les deux autres servent d'entrée différentielle pour l'amplification.

Ce circuit amplificateur et sommateur différentiel double à quatre entrées indépendantes est caractérisé en ce qu'il comprend :

- deux lignes équipotentielles d'alimentation L1 et L2 portées respectivement aux potentiels -V et +V ;
- quatre transistors amplificateurs MOS, M1, M2, M3 et M4 dont les grilles constituent les entrées e1, e2, e3, e4, du circuit et sont respectivement branchées sur des sources délivrant les tensions à amplifier de valeurs Ve1, Ve2, Ve3, Ve4, les drains D1, D2, D3, D4 desdits transistors étant connectés deux à deux, à savoir respectivement ceux D1 et D3 des transistors M1 et M3 d'une part pour constituer la première sortie du circuit sur laquelle on recueille la tension amplifiée Vs1, et ceux D2 et D4 des transistors M2 et M4 d'autre part pour constituer la seconde sortie du circuit sur laquelle on recueille la tension amplifiée Vs2 ;
- quatre résistances de charge M5, M6, M7 et M8 reliant respectivement les drains D1, D2, D3, D4 des transistors M1, M2, M3 et M4 à la ligne équipotentielle L1 ;
- un transistor MOS, M9 fonctionnant en générateur de courant, dont le drain D9 est relié au point commun aux quatre sources S1, S2, S3, S4 des transistors M1, M2, M3, M4 dont la source S9 est reliée à la ligne équipotentielle L2 et dont la grille g9 est reliée à une source de tension de polarisation Upol3.

Selon une variante particulièrement intéressante de la présente invention, le circuit amplificateur utilise comme résistance de charge quatre transistors MOS travaillant en zone ohmique et :

- dont les drains D5, D6, D7, D8 sont reliés directement la ligne L1, les sources S5, S6, S7, S8 desdits transistors étant connectées directement aux drains D1, D2, D3, D4 des transistors M1, M2, M3, M4 ;
- dont à les grilles G5 et G6 de M5 et M6 sont reliées à une source de polarisation Upol1 et les grilles G7 et G8 de M7 et M8 sont reliées à une source de polarisation Upol2, les polarisations Upol1 et Upol2 pouvant être identiques.

Dans un premier mode de mise en oeuvre de l'invention, la compensation de tension d'offset du circuit amplificateur est réalisée par une commande externe; dans ce mode de mise en oeuvre, les tensions de polarisation Upol1 et Upol2 sont égales entre elles et à la tension de sortie Vs1, Les tensions Ve1 et Ve2 constituent les entrées respectivement >0 et <0 de l'amplificateur, l'entrée e3 est portée au potentiel de la masse, la tension Ve4 étant utilisée comme commande externe de compensation et la tension de sortie Vs2 comme tension de sortie de l'amplificateur.

Dans un deuxième mode de mise en oeuvre de l'invention, la compensation de tension d'offset est réalisée automatiquement, cette dernière étant portée dynamiquement à une valeur minimale à l'aide d'une combinaison de deux circuits amplificateurs A1 et A'1 réalisés sur la même puce de circuit intégré et fonctionnant par conséquent dans des conditions quasiment identiques en ce qui concerne les influences extérieures (notamment les rayonnements par exemple) auxquelles ils sont soumis. Dans une réalisation de ce genre, le deuxième amplificateur A'1 fonctionne comme une "image" du premier et fournit à chaque instant la valeur de la correction à effectuer au premier amplificateur pour rendre minimales les variations du point de fonctionnement de celui-ci qui se trouve ainsi automatiquement stabilisé.

Dans ce mode de mise en oeuvre, le premier amplificateur A1 est bouclé en gain unitaire avec son entrée e1 reliée à sa sortie S1 et ses trois entrées e2, e3, e4 à la masse ; le second A'1 est l'image du premier, et ses entrées e'1 et e'4 constituent les entrées positive et négative de l'amplificateur différentiel A ; l'entrée e'2 est reliée la masse.

En se référant maintenant aux figures 2 à 4 ci-jointes on décrira ci-après trois exemples de réalisation et d'application du circuit amplificateur différentiel selon l'invention, donnés à titre illustratif et non limitatif, figures sur lesquelles :

- la figure 2 représente le schéma général de principe du circuit amplificateur et sommateur différentiel de l'objet de l'invention ;
- la figure 3a représente la première application du circuit de la figure 2 dans un mode de mise en oeuvre à compensation réalisée par commande externe ;
- la figure 3b représente le schéma équivalent du circuit amplificateur de la figure 3a ;
- la figure 4 représente une application du circuit amplificateur différentiel objet de l'invention, dans une version à deux circuits A1 et A'1 permettant une compensation automatique des variations de la tension d'offset.

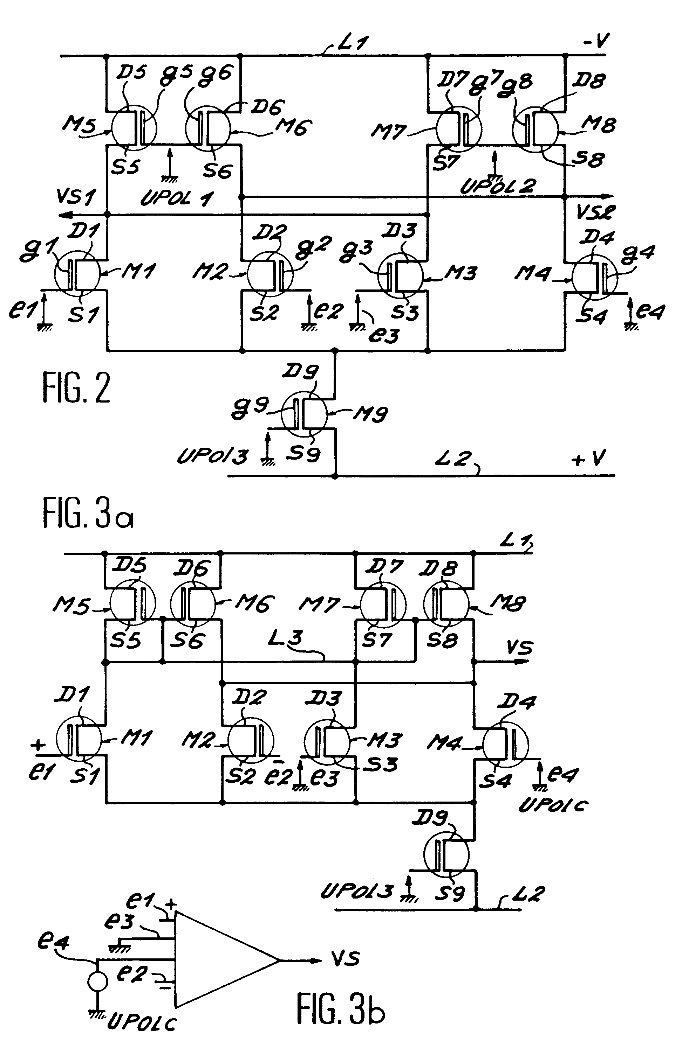

Sur la figure 2, on a représenté d'abord les deux lignes équipotentielles L1 et L2 reliées respectivement à des sources de tension -V et +V qui servent d'alimentation au circuit amplificateur. La partie proprement amplificatrice comporte quatre transistors de type MOS désignés respectivement sur la figure par M1, M2, M3, M4 qui sont branchés de la façon suivante : leurs grilles respectives g1, g2, g3 et g4 constituent les quatre entrées e1, e2, e3 et e4 du circuit amplificateur. A ces entrées sont appliquées les tensions à amplifier désignées respectivement par Ve1, Ve2, Ve3 et Ve4. Les drains D1, D2, D3 et D4 des quatre transistors M1, M2, M3 et M4 sont reliés chacun à la ligne équipotentielle L1 à travers des résistances de charge M5, M6, M7 et M8. Ces résistances peuvent être constituées de différentes façons connues ; dans l'exemple de la figure 2, elles sont réalisées de façon simple à l'aide de transistors MOS M5, M6, M7 et M8 travaillant en zone ohmique. A cet effet, les transistors M5, M6, M7 et M8 sont respectivement connectés par leurs sources S5, S6, S7 et S8 aux drains D1, D2, D3 et D4 des transistors M1, M2, M3 et M4.

Selon l'invention également les transistors M1 et M3 d'une part et M2 et M4 de l'autre ont leurs drains D1 et D3 ainsi que D2 et D4 reliés deux à deux pour constituer les sorties Vs1 et Vs2 du circuit amplificateur différentiel.

Enfin, un transistor M9 utilisé en générateur de courant a son drain D9 relié au point commun aux sources S1, S2, S3 et S4 des transistors M1, M2, M3 et M4 et sa source S9 connectée à la ligne équipotentielle L2. Ce transistor générateur de courant M9 a sa grille g9 reliée à une source de polarisation Upol3.

Enfin, deux sources de polarisation Upol1, Upol2 qui peuvent être identiques sont appliquées respectivement aux points communs aux grilles g5 et g6 des transistors M5 et M6 et g7 et g8 des transistors M7 et M8.

Si l'on appelle G le gain en amplification de chacun des transistors M1, M2, M3 et M4, on peut écrire les équations suivantes qui traduisent les rapports entre les tensions d'entrée et de sortie des différents transistors MOS précédents :

$$Vs1 = G (Ve1 + Ve3)$$
$$Vs2 = G (Ve2 + Ve4)$$
$$Vs1-Vs2 = G\{(Ve1 + Ve3) - (Ve2 + Ve4)\}$$

On voit donc finalement que le circuit amplificateur différentiel de la figure 1 donne des tensions de sortie Vs1 et Vs2 dont la différence est une combinaison linéaire des tensions d'entrée associées deux à deux, respectivement Ve1 et Ve3 d'une part et Ve2 et Ve4 de l'autre. C'est cette formulation qui était le but recherché qui justifie l'intérêt général de ce circuit et la possibilité, en particulier, de l'utiliser avec un réglage manuel ou automatique de son point de fonctionnement, c'est-à-dire notamment de sa tension d'offset, à l'aide d'une source extérieure de polarisation comme on le comprendra en se référant aux deux exemples suivants des figures 3 et 4.

Sur la figure 3a, on a représenté un mode de mise en oeuvre de l'application du circuit amplificateur dans lequel la tension d'offset est compensée à l'aide d'une commande externe manuelle.

Dans ce circuit on retrouve les mêmes éléments que ceux de la figure 2 qui portent les mêmes nombres de références, aux différences significatives près suivantes: les tensions de polarisation Upol1 et Upol2 sont cette fois égales entre elles et égales à la tension de sortie Vs1 comme le réalise le conducteur l3 qui injecte la tension Vs1 de la figure 2 aux points communs aux grilles g5, g6 d'une part et g7, g8 d'autre part ; la commande de correction manuelle externe est réalisée au travers du transistor M4 dont la grille g4 sert d'entrée e4 à la tension de polarisation de correction Upolc. Enfin, la sortie Vs2 est utilisée dans ce montage comme sortie Vs du circuit amplificateur tout entier.

Sur la figure 3b qui représente le schéma synoptique du circuit de la figure 3a, on a schématisé le branchement du circuit amplificateur différentiel comportant les quatre entrées e1, e2, e3 et e4 dont e1 et e2 constituent les entrées positive et négative de l'amplificateur ; l'entrée e3 est à la masse et l'entrée e4 reçoit la tension de polarisation de contrôle Upolc du point de fonctionnement de l'amplificateur. La tension Vs est la tension de sortie correspondant à la sortie Vs2 de la figure 2.

Dans un mode de mise en oeuvre de ce genre, on peut à chaque instant, grâce à la linéarité des formules précédentes exprimant les différences de tension, réaliser à chaque instant en modifiant la tension de polarisation de contrôle appliquée à l'entrée e4, le réglage du point de fonctionnement et la compensation souhaitée de la valeur d'offset instantanée de l'amplificateur.

Le circuit de la figure 4 qui sera maintenant décrit, concerne l'application du circuit amplificateur de la figure 3a précédente à la réalisation d'un amplificateur différentiel dont la tension d'offset est minimisée dynamiquement de façon automatique ; à cet effet, le circuit représenté comporte, sur la même puce de circuit intégré et disposés de façon connue sous forme imbriquée l'un dans l'autre de façon à avoir un axe de symétrie commun et donc les mêmes caractéristiques électriques, deux amplificateurs identiques à savoir A1, A′1, dont le second est l'image de l'autre, leurs branchements respectifs étant réalisésde la façon suivante.

L'amplificateur différentiel à quatre entrées A1 conforme à l'invention, est monté bouclé sur lui-même en gain unitaire, c'est-à-dire que l'entrée e1 est liée à la sortie S1 de cet amplificateur. Les trois autres entrées e2, e3 et e4 sont mises à la masse. La sortie S1 de l'amplificateur A1 alimente directement l'entrée e′3 de l'amplificateur image A′1. L'entrée e′2 de l'amplificateur A′1 est mise à la masse et les deux entrées extrêmes e′1 et e′4 constituent respectivement les entrées positive et négative de l'amplicateur global A. C'est la sortie S′1 de l'amplificateur image A′1 qui constitue la sortie de l'amplificateur A.

Les deux amplificateurs A1 et A′1 étant identiques et situés pratiquement dans l'espace au même endroit de la même puce, ont des points de fonctionnement comparables et la linéarité des différentes tensions de sortie en fonction des tensions d'entrée est cause du fait que l'amplificateur image A′1 réalise automatiquement à chaque instant la correction optimale de la tension d'offset de l'amplificateur A1. On réalise ainsi en circuit intégré sur une même puce, de façon très commode en raison de l'identité de constitution des amplificateurs A1 et A′1 un amplificateur global A corrigé dynamiquement et automatiquement des défauts de sa tension d'offset.

Cette correction de la tension d'offset de l'amplificateur A est efficace dès lors que l'on peut considérer que les deux amplificateurs A1 et A′1 sont images l'un de l'autre et ceci quelles que soient les variations de leurs points de fonctionnement au cours du temps. La compensation ainsi obtenue n'a plus besoin d'être réglée de l'extérieur et elle évolue spontanément suivant le comportement des deux amplificateurs au cours du temps.

## Revendications

1. Circuit amplificateur et sommateur différentiel double à quatre entrées indépendantes e1, e2, e3, e4, caractérisé en ce qu'il comprend :
   - deux lignes équipotentielles d'alimentation (L1) et (L2) portées respectivement aux potentiels -V et +V ;
   - quatre transistors amplificateurs MOS, M1, M2, M3 et M4 dont les grilles constituent les entrées e1, e2, e3, e4, du circuit et sont respectivement branchées sur des sources délivrant les tensions à amplifier de valeurs Ve1, Ve2, Ve3, Ve4, les drains D1, D2, D3, D4 desdits transistors étant connectés deux à deux, à savoir respectivement ceux D1 et D3 des transistors M1 et M3 d'une part pour constituer la première sortie du circuit sur laquelle on recueille la tension amplifiée Vs1, et ceux D2 et D4 des transistors M2 et M4 d'autre part pour constituer la seconde sortie du circuit sur laquelle on recueille la tension amplifiée Vs2 ;

- quatre résistances de charge M5, M6, M7 et M8 reliant respectivement les drains D1, D2, D3, D4 des transistors M1, M2, M3 et M4 à la ligne équipotentielle L1 ;
- un transistor MOS, M9 fonctionnant en générateur de courant, dont le drain D9 est relié au point commun aux quatre sources S1, S2, S3, S4 des transistors M1, M2, M3, M4 dont la source S9 est reliée à la ligne équipotentielle L2 et dont la grille g9 est reliée une source de tension de polarisation Upol3.

2. Circuit amplificateur et sommateur différentiel double selon la revendication 1, caractérisé en ce que les résistances de charges M5, M6, M7, M8 sont constituées par des transistors MOS travaillant en zone ohmique et :

- dont les drains D5, D6, D7, D8 sont reliés directement à la ligne L1, les sources S5, S6, S7, S8 desdits transistors étant connectées directement aux drains D1, D2, D3, D4 des transistors M1, M2, M3, M4 ;
- dont les grilles G5 et G6 de M5 et M6 sont reliées à une source de polarisation Upol1 et les grilles G7 et G8 de M7 et M8 sont reliées à une source de polarisation Upol2, les polarisations Upol1 et Upol2 pouvant être identiques.

3. Circuit amplificateur différentiel selon la revendication 1 à transistor MOS à tension d'offset compensée par commande externe, caractérisé en ce que les tensions de polarisation Upol1 et Upol2 sont égales entre elles et à la tension de sortie Vs1, les entrées e1 et e2 constituent les entrées respectivement >0 et <0 de l'amplificateur, l'entrée e3 étant mise à la masse, la tension Ve4 étant utilisée comme commande externe de compensation et la tension de sortie Vs2 comme tension de sortie de l'amplificateur.

4. Circuit amplificateur différentiel à transistor MOS dont la tension d'offset est minimisée dynamiquement de façon automatique, caractérisé en ce qu'il comporte deux circuits différentiels doubles A1 et A′1 selon la revendication 3, à quatre entrées respectives e, e2, e3, e4 et e′1, e′2, e′3, e′4 indépendantes, le premier A1, étant bouclé au gain unitaire avec son entrée R1 reliée à sa sortie S1 et ses trois entrées e2, e3, e4 à la masse, le second A′1, image du premier, recevant sur son entrée E′3 la tension de sortie S1 du premier, les entrées e′1 et e′4 de A′1 constituant les entrées positive et négative de l'amplificateur différentiel, et l'entrée e′2 étant reliée à la masse.

## Claims

1. Double differential summing amplifier circuit with four independent inputs e1, e2, e3, e4, characterized in that it comprises two equipotential supply lines L1 and L2 raised respectively to potent as -V and +V; four MOS amplifier transistors M1, M2, M3 and M4, whereof the gates constitute the inputs e1, e2, e3 and e4 of the circuit and which are respectively connected to sources supplying the voltages to be amplified of values Ve1, Ve2, Ve3 and Ve4, the drains D1, D2, D3 and D4 of said transistors being connected pairwise, namely D1 and D3 of transistors M1 and M3 on the one hand for constituting the first output of the circuit on which is collected the amplified voltage Vs1 and D2 and D4 of transistors M2 and M4 on the other hand for constituting the second output of the circuit on which is collected the amplified voltage Vs2; four load resistors M5, M6, M7 and M8 respectively connecting the drains D1, D2, D3 and D4 of transistors M1, M2, M3 and M4 to equipotential line L1; an MOS transistor M9 functioning as a current generator, whose drain D9 is connected to the common point of the four sources S1, S2, S3 and S4 of transistors M1, M2, M3 and M4, whereof the source S9 is connected to equipotential line L2 and whose gate g9 is connected to a polarizing voltage source Upo13.

2. Double differential summing amplifier circuit according to claim 1, characterized in that the load resistors M5, M6, M7, M8 are constituted by MOS transistors operating in the ohmic zone and whose drains D5, D6, D7, D8 are directly connected to line L1, the sources S5, S6, S7, S8 of said transistors being directly connected to drains D1, D2, D3 and D4 of transistors M1, M2, M3 and M4 and whereof the gates G5, G6 of M5, M6 are connected to a polarization source Upo11 and gates GT, G8 of M7, M8 are connected to a polarization source Upo12, whereby polarizations Upo11 and Upo12 can be identical.

3. Differential amplifier circuit according to claim 1 with a MO5 transistor and an offset voltage compensated by external control, characterized in that the polarizing voltages Upo11 and Upo12 are equal to one another and to the output voltage Vs1, inputs e1 and e2 constituting the inputs respectively >0 and <0 of the amplifier, input e3 being connected to ground and voltage Ve4 used as the external compensation control and output voltage Vs2 as the output voltage of the amplifier.

4. Differential amplifier circuit with MOS transistor, whose offset voltage is dynamically minimized automatically, characterized in that it comprises two double differential circuits A1 and A'1 according to claim 3, with four respective inputs e, e2, e3, e4 and e'1, e'2, e'3, e'4, which are independent, the first A1, being looped in unitary gain with its input R1 connected to its output S1 and its three inputs e2, e3, e4 to ground, the second A'1, which is the image of the first, receiving on its input e'3 the output voltage S1 from the first, inputs e'1 and e'4 of A'1 constituting the positive and negative inputs of the differential amplifier, whilst input e'2 is connected to ground.

**Patentansprüche**

1. Doppelter differentieller Summierverstärker mit vier unabhängigen Eingängen e1, e2, e3, e4, dadurch gekennzeichnet, daß er umfaßt:
   - zwei äquipotentiale Versorgungsleitungen (L1) und (L2), die jeweils auf die Potentiale +V und -V gebracht sind;
   - vier MOS-Verstärkertransistoren M1, M2, M3 und M4, deren Gates die Eingänge e1, e2, e3, e4 des Schaltkreises bilden und jeweils mit Sources verbunden sind, die die zu verstärkenden Spannungen mit den Werten Ve1, Ve2, Ve3, Ve4 liefern, wobei die Drains D1, D2, D3, D4 der Transistoren paarweise verbunden sind, das heißt jeweils diejenigen D1 und D3 der Transistoren M1 und M3 auf der einen Seite, um den ersten Ausgang des Schaltkreises zu bilden, auf dem man die verstärkte Spannung Vs1 erhält, und diejenigen D2 und D4 der Transistoren M2 und M4 auf der anderen Seite, um den zweiten Ausgang des Schaltkreises zu bilden, auf dem man die verstärkte Spannung Vs2 erhält;
   - vier Lastwiderstände M5, M6, M7 und M8, die jeweils die Drains D1, D2, D3, D4 der Transistoren M1, M2, M3 und M4 mit der Äquipotentialleitung L1 verbinden;
   - einen MOS-Transistor M9, das als Stromquelle arbeitet, dessen Drain D9 mit einem mit den vier Sources S1, S2, S3, S4 der Transistoren M1, M2, M3, M4 gemeinsamen Punkt verbunden ist, dessen Source S9 mit der Äquipotentialleitung L2 verbunden ist und dessen Gate G9 mit einer Spannungsquelle der Polarisation Upol3 verbunden ist.

2. Doppelter differentieller Summierverstärker nach Anspruch 1, dadurch gekennzeichnet, daß die Lastwiderstände M5, M6, M7, M8 aus MOS-Transistoren bestehen, die im ohmschen Bereich arbeiten und:
   - deren Drains D5, D6, D7, D8 direkt mit der Leitung L1 verbunden sind, wobei die Sources S5, S6, S7, S8 der Transistoren direkt mit den Drains D1, D2, D3, D4 der Transistoren M1, M2, M3, M4 verbunden sind;
   - deren Gates G5 und G6 von M5 und M6 mit einer Quelle der Polarisation Upol1 und deren Gates G7 und G8 von M7 und M8 mit einer Quelle der Polarisation Upol2 verbunden sind, wobei die Polarisationen Upol1 und Upol2 identisch sein können.

3. Differentieller Verstärker nach Anspruch 1 mit MOS-Transistor mit durch externe Steuerung kompensierter Offsetspannung, dadurch gekennzeichnet, daß die Spannungen der Polarisationen Upol1 und Upol2 untereinander und zur Ausgangsspannung Vs1 gleich sind, wobei die Eingänge e1 und e2 jeweils die Eingänge >0 und <0 des Verstärkers bilden, wobei der Eingang e3 auf Masse gelegt ist, wobei die Spannung Ve4 als äußere Steuerung zur Kompensation und wobei die Ausgangsspannung Vs2 als Ausgangsspannung des Verstärkers verwendet wird.

4. Differentieller Verstärker mit MOS-Transistor, dessen Offsetspannung dynamisch automatisch minimiert wird, dadurch gekennzeichnet, daß er zwei doppelte differentielle Schaltkreise A1 und A'1 nach Anspruch 3 umfaßt mit jeweils vier unabhängigen Eingängen e1, e2, e3, e4 und e'1, e'2, e'3, e'4, wobei der erste A1 mit seinem Eingang R1 mit dem Ausgang S1 verbunden und mit seinen drei Eingängen e2, e3, e4 mit der Masse verbunden als Schleife mit Einheitsverstärkung geschaltet ist und wobei der zweite A'1, das Spiegelbild des ersten, auf seinem Eingang e'3 die Ausgangsspannung S1 des ersten erhält, wobei die Eingänge e'1 und e'4 von A'1 die positiven und negativen Eingänge des differentiellen Verstärkers bilden und wobei der Eingang e'2 mit der Masse verbunden ist.

FIG. 1

FIG. 4

FIG. 2

FIG. 3a

FIG. 3b